# EUROPEAN PATENT APPLICATION

(11) **EP 4 231 353 A1**
(43) Date of publication of application: **23.08.2023**
(21) Application number: 22156961.9
(22) Date of filing: 16.02.2022
(51) Int. Cl.: H01L 27/105, G11C 19/28, H01L 29/423, H01L 29/765

(54) **A 3D INTEGRATED CHARGE-COUPLED DEVICE MEMORY**

(71) Applicant: Imec VZW, 3001 Leuven (BE)
(72) Inventor: Rosmeulen, Maarten, 3001 Leuven (BE); Lee, Jiwon, 3001 Leuven (BE); Kar, Gouri Sankar, 3001 Leuven (BE); Mahato, Swaraj Bandhu, 3001 Leuven (BE)
(74) Representative: Roth, Sebastian

(57) **Abstract**

This disclosure relates to a charge-coupled device (CCD) memory. The CCD memory is 3D integrated. The CCD memory comprises a gate stack with a plurality of gate layers and spacer layers alternatingly arranged one on the other, and with a plurality of semiconductor-based channels extending in the stack. The channels may be formed from a semiconductor oxide material. Further, the CCD memory comprises dielectric layers, wherein each dielectric layer is arranged between one of the channels and at least one of the gate layers. Each channel of the CCD memory forms, in combination with the gate layers and at least one of the dielectric layers, a string of charge storage capacitors, and each string of charge storage capacitors is operable as a CCD register. The CCD memory also comprises a readout layer, which comprises a plurality of readout stages configured to individually readout stored charge from each of the CCD registers.

## Description

### TECHNICAL FIELD

The present disclosure relates to a charge-coupled device (CCD) memory. In particular, the CCD memory is a 3D integrated memory device, and may comprise memory channels that are formed from at least one semiconductor oxide material and/or semiconductor material.

### BACKGROUND OF THE INVENTION

The insatiable demand for working memory is increasingly confronted with limitations in dynamic random access memory (DRAM) capacity. The slowing down of conventional DRAM scaling has prompted the search for new types of memory, in order to bridge the gap between low-cost storage memory and highspeed working memory.

Various types of so-called storage class memory (SCM) have been proposed, but no satisfactory solution has emerged yet. The available alternatives lack either scalability (e.g., the phase change memory), or power efficiency (e.g., the magnetoresistive random access memory), or cycling capability (e.g., the lowlatency NAND memory).

Viable options for SCM need to provide a significant cost advantage over DRAM. Also, it is imperative to have data block latencies comparable to DRAM, for both read and write operations. Also, an essentially unlimited cycling capability and an extremely reliable operation should be provided. Finally, the active power consumption should be at least as low as DRAM, and a stand-by power preferably better than DRAM.

### SUMMARY OF THE INVENTION

In view of the above, an objective of this disclosure is to provide a new kind of SCM, which has a cost-advantage over DRAM and which has a comparable speed than DRAM. Another objective is to achieve a SCM with a high retention time and with a low power consumption.

These and other objectives are achieved by the solutions of this disclosure as described in the independent claims. Advantageous implementations are defined in the dependent claims.

The solutions of this disclosure are based on the following considerations of the inventors.

The simultaneous technical requirements on speed, reliability, cycling, and power, have so far been realized only by static random access memory (SRAM) and DRAM. This fact points towards such traditional charge-based semiconductor components as suitable building blocks for a new SCM. Moreover, the extreme density realized by 3D-NAND Flash memory suggests further, that a series connection of metal-oxide-semiconductor field effect transistors (MOSFETs) may be a possible route towards achieving the additional requirement on low cost.

Notably, CCDs combine the aspects mentioned above, and indeed were envisaged once to serve as semiconductor memory. However, the CCDs lack the byte-addressability, which is conventionally required for RAM. One idea employed in this disclosure is to trade this byte-addressability for lower cost. Based on this, the disclosure proposes a CCD-based block-addressable SCM as a fundamentally new class of memory.

A first aspect of this disclosure provides a 3D integrated CCD memory comprising: a gate stack including a plurality of gate layers and spacer layers alternatingly arranged one on the other along a first direction; a plurality of semiconductor-based channels extending in the stack; a plurality of dielectric layers, each dielectric layer being arranged between one of the semiconductor-based channels and at least one of the gate layers; and a readout layer, wherein the gate stack is arranged on the readout layer; wherein each semiconductor-based channel forms, in combination with the gate layers and at least one of the dielectric layers, a string of charge storage capacitors; wherein each string of charge storage capacitors is operable as a CCD register; and wherein the readout layer comprises a plurality of readout stages configured to individually readout stored charge from each of the CCD registers.

The charge storage capacitors may be connected in series to form the CCD register. The charge storage capacitors may be MOS capacitors. The CCD register may be considered a memory cell of the CCD memory.

By integrating the CCD memory in 3D - i.e., by building the stack of the gate and the spacer layers along the first direction, and by forming the channels in this stack, preferably aligned vertically along the first direction - a high density like in 3D NAND Flash can be achieved. Thus, the costs (per stored bit) become low. The CCD memory can be used as SCM, under the premise that the byte-addressability can be omitted. The CCD memory provides also high speeds, good reliability, nearly unlimited cycling, and low power consumption.

In an implementation of the CCD memory, at least one semiconductor-based channel is made of a semiconductor oxide material.

This significantly increases the retention time of the CCD memory.

In an implementation of the CCD memory, the semiconductor oxide material comprises at least one of: indium gallium zinc oxide, IGZO; indium tin oxide, ITO; indium zinc oxide, IZO.

For instance, recent developments in wide-bandgap oxide semiconductors such as the IGZO make possible to practically integrate in 3D the CCD registers with a sufficiently high retention time.

In an implementation of the CCD memory, at least one semiconductor-based channel is made of a silicon-based semiconductor material or III-V semiconductor material.

This material choice may reduce the cost of the CCD memory, at least due to compatibility with existing CMOS process flows.

In an implementation of the CCD memory, each CCD register is connected to one of the readout stages, which is configured to readout stored charge from the connected CCD register.

In this way, each CCD register can be read out individually, e.g., the charges stored in one CCD register can be read out concurrently with other CCD registers.

In an implementation of the CCD memory, each CCD register is connected to a write stage configured to push charge into the CCD register.

In an implementation of the CCD memory, the readout stage and the write stage of the CCD register are connected to different ends of the semiconductor-based channel that is associated with the CCD register.

In an implementation of the CCD memory, the readout stage and the write stage of the CCD register are integrated with another and are connected to one end of the semiconductor-based channel that is associated with the CCD register.

In an implementation of the CCD memory, at least a part of each semiconductor-based channel extends along the first direction and/or extends perpendicular to parallel surfaces of the gate layers.

In an implementation of the CCD memory, at least one semiconductor-based channel is straight in the stack.

In an implementation of the CCD memory, at least one semiconductor-based channel has a bend in the stack, in particular, has a U-shape.

In an implementation of the CCD memory, at least one semiconductor-based channel is a macaroni-type channel.

The above implementation forms enable different kinds of geometries of the CCD memory.

In an implementation of the CCD memory, each gate layer surrounds one or more of the semiconductor-based channels.

This enables a gate-all-around (GAA) architecture.

In an implementation of the CCD memory, the gate stack further comprises an input transfer-gate layer and an output transfer-gate layer, which sandwich the gate layers and the spacer layers of the gate stack in the first direction; wherein the input transfer-gate layer and the output transfer-gate layer respectively comprise a plurality of transfer-gates for accessing the CCD registers; wherein the output transfer-gate layer of the gate stack is formed on the readout layer, and wherein the transfer gates of the output transfer-gate layer are connected to the readout stages of the readout layer.

### BRIEF DESCRIPTION OF THE DRAWINGS

The above described aspects and implementations are explained in the following description of embodiments with respect to the enclosed drawings:
- FIG. 1: shows a CCD memory according to an embodiment of this disclosure.
- FIG. 2: shows a CCD memory according to an embodiment of this disclosure
- FIG. 3: shows various possible CCD registers of a CCD memory according to an embodiment of this disclosure.
- FIG. 4: shows measurement data for measuring the retention time of a CCD register of a CCD memory according to an embodiment of this disclosure with a semiconductor oxide based channel.
- FIG. 5: shows retention time results of the measurements shown in FIG. 4.

### DETAILED DESCRIPTION OF EMBODIMENTS OF THE INVENTION

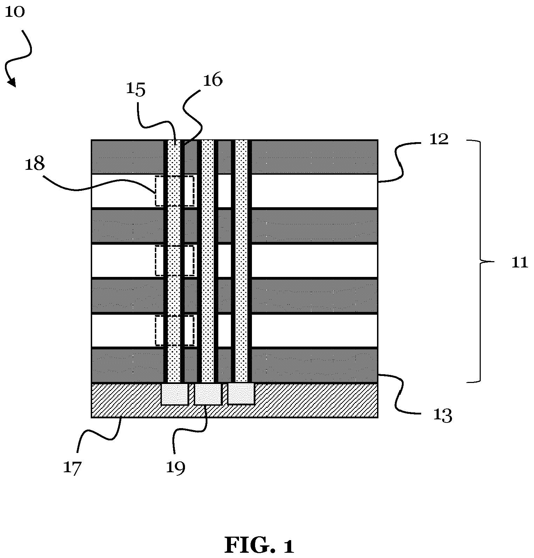

FIG. 1 shows a CCD memory 10 according to an embodiment of this disclosure. The CCD memory 10 may serve as a SCM. The CCD memory 10 is three-dimensional (3D) and an integrated device. The CCD memory 10 may be fabricated in a CMOS compatible process flow.

The 3D integrated CCD memory 10 comprises a gate stack 11. The gate stack 11 includes a plurality of gate layers 12 and spacer layers 13, which are alternatingly arranged one on the other along a first direction 14. The first direction 14 is thus a stacking direction of the layers 12/13 of the gate stack 11, and may be a growth direction if the gate layers 12 and the spacer layers 13 are, respectively, formed by a growth technique like epitaxy, chemical vapor deposition, or the like.

The gate stack 11 may begin with a first spacer layer 13, on which a first gate layer 12 is formed, on which a second spacer layer 13 is formed, on which a second gate layer 12 is formed, and so on. Also the last-formed layer of the gate stack 11 may be a spacer layer 13. Accordingly, there may be more spacer layers 13 than gate layers 12 in the gate stack 11. However, the number of the gate layers 12 may also be equal to the number of spacer layers 13 in the gate stack 11.

The gate layers 12 may each comprise at least one of the following materials: Cu, Al, Ti, W, Ni, Au, TiN, TaN, TaC, NbN, RuTa, Co, Ta, Mo, Pd, Pt, Ru, Ir, and Ag. The spacer layers 11 may each comprise at least one of the following materials: SiO₂, SiO, SiN, SiON, Al₂O₃, AlN, MgO, and carbides.

The CCD memory 10 further comprises a plurality of semiconductor-based channels 15, which extend in the stack 11. That is, each channel 15 extends in the gate stack 11. Thereby, one or more channels 15 may extend straight in the gate stack 11 (as shown in FIG. 1, e.g., along the first direction 14). Alternatively or additionally, one or more channels 15 may extend with a bend in the gate stack 11. For example, they may have a U-shape. Multiple channels 15 of the plurality of semiconductor-based channels 15 may extend in parallel in the gate stack 11 (as shown in FIG. 1). Each channel 15 may pass the gate layers 12 of the stack 11 - i.e. the gate layers 12 may be arranged next to the channel 15 - of may go through the gate layers 12 of the stack 11 - i.e. the gate layers 12 may surround the channel 15. Each gate layer 12 can surround one or more of the semiconductor-based channels 15.

The one or more channels 15 may each be made of a semiconductor oxide material. For example, at least one semiconductor-based channel 15 may be made of one or more semiconductor oxide materials. The semiconductor oxide material(s) that maybe used to form the channels 15 can comprise at least one of IGZO, indium tin oxide (ITO), and indium zinc oxide (IZO). The semiconductor oxide material(s) that may be used to form the channels 15 can additionally or alternatively comprise at least one of indium oxide (InO), indium tin zinc oxide (InSnZnO), cadmium oxide (CdO), gallium oxygen (GaO), tin oxide (SnO), zinc oxide (ZnO), zinc tin oxide (ZnSnO), aluminum indium zinc tin oxide (AlInZnSnO), magnesium indium gallium zink oxide (MgInGaZnO), and tungsten indium oxide (WInO). At least one of the channels 15 may further be made of a silicon-based semiconductor material or of an III-V semiconductor material. For example, possible semiconductor materials that may be used to form the channels comprise silicon (Si), silicon germanium (SiGe), germanium (Ge), gallium arsenide (GaAs), gallium arsenide phosphide (GaAsP), indium arsenide (InAs), indium antimonide (InSb), and indium phosphide (InP).

The CCD memory 10 further comprises a plurality of dielectric layers 16, wherein each dielectric layer 16 is arranged between one of the semiconductor-based channels 15 and at least one of the gate layers 12. Each dielectric layer 16 can be arranged parallel to one channel 15, or can surround one channel 15. Thereby, the dielectric layer 16 can isolate said channel 15 from each of the gate layers 12. As mentioned before, the gate layers 12 can be arranged next to the semiconductor-based channel 15 or can surround the semiconductor-based channel - with the dielectric layer 16 in between in each case.

The gate electrode layers 12, the dielectric layer(s) 16, and the semiconductor-based channel 15 may be arranged in a GAA vertical channel structure, wherein the dielectric layer 16 is wrapped completely around the channel 15, and the gate layers 12 are wrapped completely around the dielectric layer 16 and the channel 15. Further, the spacer layers 13 may also be wrapped completely around the dielectric layer 16 and the channel 16. The dielectric material of the dielectric layer 16 may comprise at least one of the following materials: aluminum oxide (Al₂O₃), silicon oxide (SiO₂), silicon nitride (SiN), and a low-k material.

Each semiconductor-based channel 15 can be formed by creating (e.g., etching or drilling) a hole into the gate stack 11, forming the dielectric layer(s) 16 inside the hole, and then filling the hole with the semiconductor-based material. Each semiconductor-based channel 15 may thereby extend along the first direction 14 and/or may extend perpendicular to the parallel surfaces of the gate layers 12 arranged one above another (with the spacer layers 13 in between) along the first direction 14.

Each semiconductor-based channel 15 forms, in combination with the gate layers 12 and at least one of the dielectric layers 16, a string of charge storage capacitors 18. The charge storage capacitors are connected in series to form the string. Each string of charge storage capacitors 18 is operable as a CCD register of the CCD memory 10. Each charge storage capacitor may be a MOS capacitor.

The CCD memory 10 further comprises a readout layer 17. As shown in FIG. 1, the gate stack 11 is arranged on the readout layer 17. For instance, the first layer of the gate stack 11 - e.g., a spacer layer 13 - may be formed on the readout layer 17. The readout layer 17 comprises a plurality of readout stages 19, which is configured to individually readout stored charge from each of the CCD registers. For example, each CCD register may be connected to one of the readout stages 19 that is configured to readout stored charge from the connected CCD register.

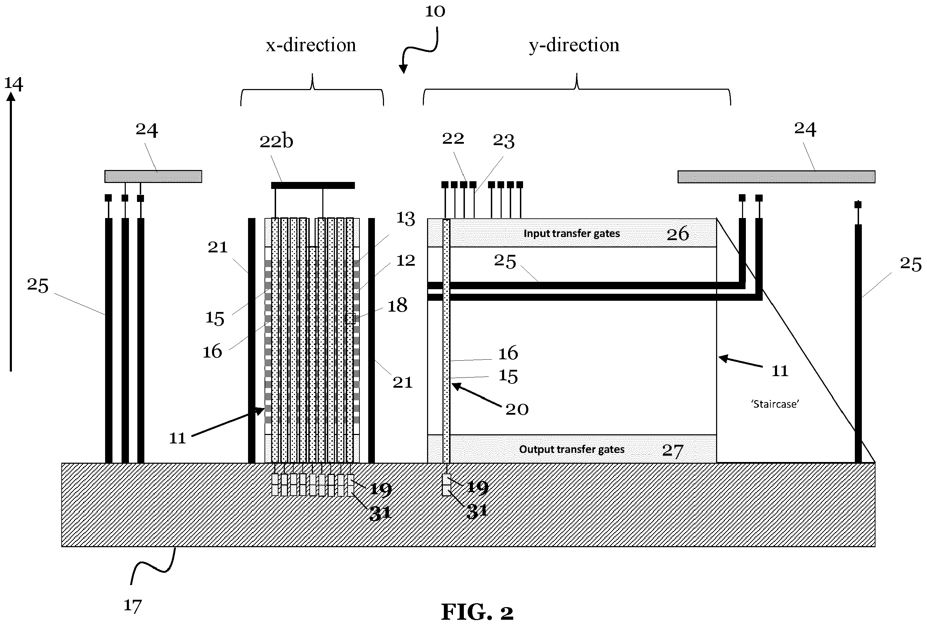

FIG. 2 shows an exemplary embodiment of the CCD memory 10, which builds on the embodiment shown in FIG. 1. Same elements in FIG. 1 and FIG. 2 are labelled with the same reference signs, and may be implemented in the same manner.

The CCD memory 10 is shown in FIG. 2 along an x-direction (left side drawing) and along a y-direction (right side drawing), wherein the first direction 14 is the z-direction, and wherein x, y and z are directions/axes of a Cartesian coordinate system.

The CCD memory 10 may comprise a plurality of bit lines 22, which may run in parallel, and corresponding bit line contacts 23 (for example, tungsten (W)). The left side drawing of FIG. 2 shows the CCD memory 10 along an x-direction that is along the bit lines 22 (notably, the bit lines could also run perpendicular to the x-direction), and the right side drawing of FIG. 2 shows the CCD memory 10 along an y-direction that is along the gate layers 12, which may be connected to gate contacts 25 (e.g., made of W), and via these gate contacts 25 further to a top interconnect 24 (e.g., made of copper (Cu) and/or aluminum (Al)). The gate contacts 25 may be arranged in a staircase configuration. Via these gate contacts 25, the gates of the charge storage capacitors 18 - that formed by the gate layers 12, dielectric layers 16, and channels 15 - can be controlled.

The gate stack 11 further comprises an input transfer-gate layer 26 and an output transfer-gate layer 27, which sandwich the gate layers 12 and the spacer layers 13 of the gate stack 11 in the first direction 14. The input transfer-gate layer 26 and the output transfer-gate layer 27 may respectively comprise a plurality of transfer-gates for accessing the CCD registers 20. By controlling these transfer gates, bit lines and the charge storage capacitor gates, charges can be stored into the CCD register 20.

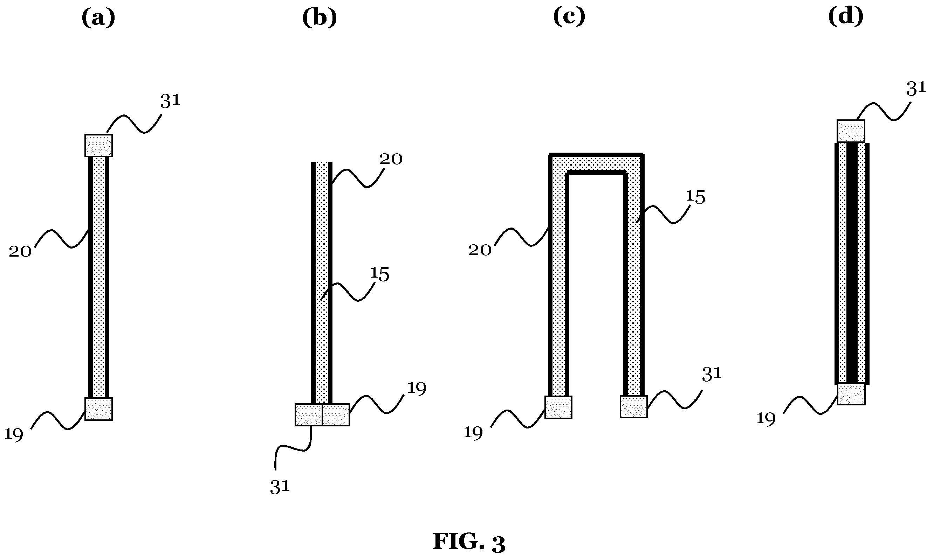

The output transfer-gate layer 27 maybe arranged on the readout layer 17, and the transfer gates of the output transfer-gate layer 27 may be connected to the readout stages 19 of the readout layer 17. The readout layer 17 contains the readout stages 19 and may contain write stages 31 (which will be discussed below in more detail with respect to FIG. 3). Each readout stage 19 and each write stage 31 may be connected to one CCD register 20. Each CCD register 20is formed by one string of charge storage capacitors 18, wherein each capacitor 18 is formed by the channel 15, at least one dielectric layer 16, and the gate layers 12 of the gate stack 11. Each write stage 31 maybe an electronic circuit configured to push/place charge into the CCD register 20. Each readout stage 19 may be a small electronic circuit used for detecting tiny charges coming out of each CCD register 20 and translating them into useful voltage signals.

The readout layer 17 may further contain additional electronic circuitry (not shown), for instance, any electronic circuitry that may be needed or beneficial to operate the CCD memory 10. This may include electronic circuitry to operate clock signals for controlling the gates of the charge storage capacitors 18. This may also include other types of control circuits for various functions, such as data input/output, buffering, coordinating, or the like.

Each readout stage 19 and/or write stage 31 may be connected to a bit line 22. There may be different types of bit lines 22. A first type of bit lines 22 is typically running on top the gate stack 11 as depicted in FIG. 2. These bit lines 22 may be to the input of the CCD registers 20 and may be used to write data into the CCD register 20. A second type of bit lines 22 may be used to read the data out of the CCD registers 20 and maybe situated at the bottom of the stack 11. These bit lines 22 may be not directly connected to the CCD register 20 outputs, but may be connected to the outputs of the readout stages 19. Since the CCD registers 20 are 3D bundles of channels 15, the readout stages 19 may be 2D arrays. The second type of bit lines 22 may run across this array to read out one single row of readout stages 19 at the same time. This second type of bit lines 22 is not indicated in FIG. 2.

The transfer gates of the input transfer-gate layer 26 may be connected to the write stages 31. By means of the write stages 31, the readout stages 19, the transfer gates, and the charge storage capacitor's gates formed by the gate layers 12, the CCD register 20 can be operated.

It can also be seen in FIG. 2 that the CCD memory 10 may comprise more than one gate stack 11. For instance, in the left side of FIG. 2 two gate stacks 11 are illustrated. The two gate stacks 11 are separated by block separators 21, which may be made of tungsten. Multiple gate stacks 11 may be connected to the same bit line(s) 22.

FIG. 3 shows various examples of how the CCD registers 20 of the CCD memory 10 of FIG. 1 or FIG. 2 could be formed. As shown in FIG. 3, each CCD register 20 comprises a semiconductor-based channel 15, which is connected to a readout stage 19 and a write stage 31 (connection shown is only schematic). Other elements of the CCD registers 20, particularly the stack 11 and dielectric layers 16 are not shown in FIG. 3.

As shown in FIG. 3(a) - similar to what is shown in FIG. 1 and FIG. 2 as example -at least one or all semiconductor-based channels 15 may be straight in the gate stack 11. Further, a readout stage 19 and a write stage 31 associated with this CCD register 20 may be connected to different ends of the semiconductor-based channel 15 of the CCD register 20.

Alternatively, as shown in FIG. 3(b), the readout stage 19 and the write stage 31 of the CCD register 20 may also be formed integrated with another or connected to each other. In this case, they may be connected to the same end of the semiconductor-based channel 15 of the CCD register 20.

Alternatively, as shown in FIG. 3(c), at least one or all semiconductor-based channels 15 may have a bend in the stack 11. For example, they can have a V-shape or U-shape (as illustrated in FIG. 3) in the gate stack 11. In this case, the readout stage 19 and the write stage 31 of the CCD register 20 are connected to different ends of the semiconductor-based channel 15 that is associated with the CCD register 20.

As shown in FIG. 3(a) - 3(c), at least one or all semiconductor channels 15 may be full channels. These may, for example, be formed by first creating a memory channel hole in the gate stack 11, then forming the dielectric layer(s) 16 on the wall surfaces of the hole, and then filling the remaining hole with the semiconductor-based material for the channel 15. Alternatively, as shown in FIG. 3(d), at least one or all semiconductor-based channels 15 may be a macaroni-type channel. In this case, the channel 15 may be a macaroni channel that is filled with a dielectric material, which is surrounded by the semiconductor-based channel material and the dielectric layer 16, respectively.

The CCD memory 10 of this disclosure may be usable as a SCM. This bases on the presumption that it is possible to give up the byte-addressability of, for instance, DRAM. A high storage density of the CCD memory 10 can be achieved by its 3D integration, as it is shown in FIG. 1 or FIG. 2. The 3D integration of the CCD memory 10 may be similar to that of a 3D NAND so as to allow for the high integration density. One possible implementation is by usage of poly-silicon and/or epitaxially grown channels 15.

Further, the use of a semiconductor oxide material for the channels 15 can increase significantly the retention time of the CCD memory 10. For instance, the use of an IGZO materials in the CCD memory 10 allows for sufficient retention time. This allows for a SCM that meets both the required retention time and low cost.

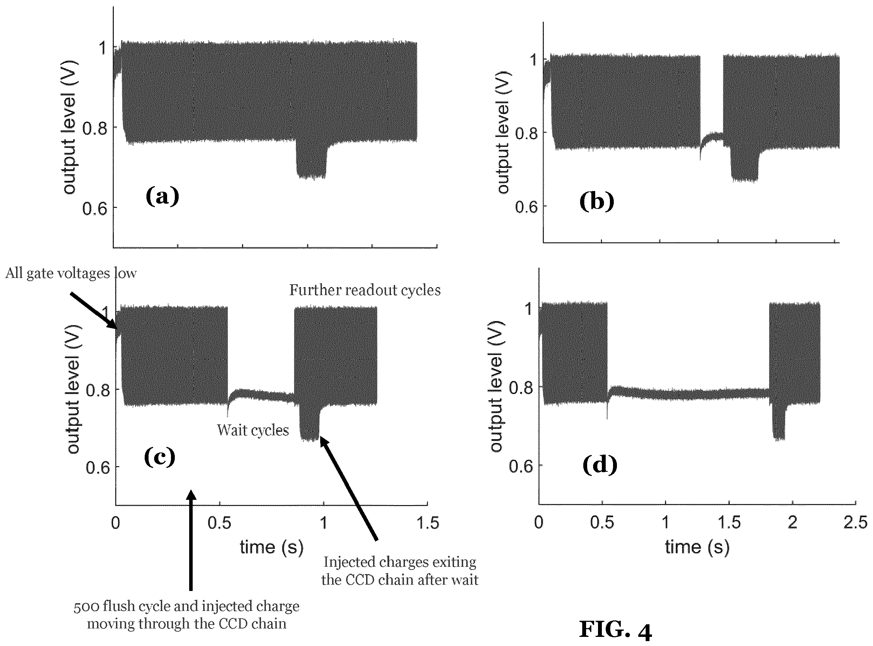

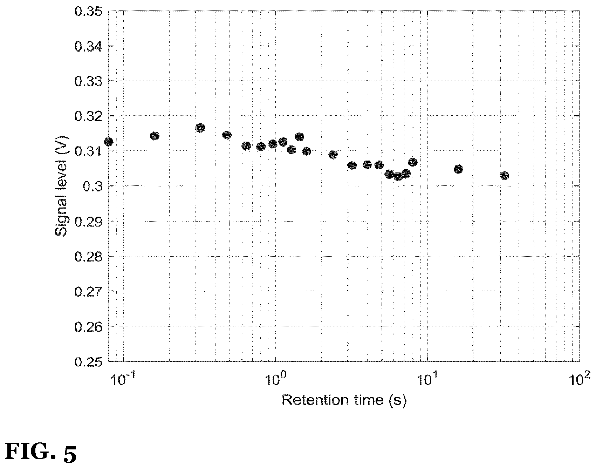

In this respect, IGZO-based CCD registers have already been realized successfully in a 300 mm fabrication process, and measurements have been performed, which confirm the operation with long retention times. The measurement results are shown in FIG. 4 and FIG. 5.

FIG. 4 shows an output level voltage (a voltage at a readout stage 19) over time for different retention time measurements, which have different numbers of wait cycles. In particular, as shown in FIG. 4(c), for all the shown measurements, in the beginning all gate voltages related to a particular CCD register 20 were set low. Then, 500 flush cycles were carried out to get rid of any pre-existing charge(s) in the CCD register 20 by just moving them out of the CCD registers 20. After that, 142 cycles of injecting charge(s) into and moving the charge(s) through the CCD register 20 were carried out. This was followed by the respective wait cycles, which numbers zero in FIG. 4(a) and which were the most in FIG. 4(d). Then, the previously injected charge(s) were readout (if still stored), which results in the characteristic drop of the output level voltage at the readout stage 19 associated with the CCD register 20 (visible in the figures). This was followed by further readout cycles, which did not result in the read out of any more charge(s) from the CCD register 20 (as can be seen, the output level voltage is again higher).

FIG. 5 summarizes the results of these measurements with different numbers of wait cycles. In particular, FIG. 5 shows a signal level in dependence of the retention time (which corresponds to the number of wait cycles). It can be seen that up to a retention time of about 32 s, the signal level remains strong, and thus indicates that the stored charges in the CCD register 20 are still captured over this time period.

In summary, a new kind of SCM based on a CCD memory 10 is provided by this disclosure, which is of low cost (high integration density), high speed, and shows a long retention time.

## Claims

1. A three-dimensional, 3D, integrated charge-coupled device, CCD, memory (10) comprising:
a gate stack (11) including a plurality of gate layers (12) and spacer layers (13) alternatingly arranged one on the other along a first direction (14);
a plurality of semiconductor-based channels (15) extending in the stack (11);
a plurality of dielectric layers (16), each dielectric layer (16) being arranged between one of the semiconductor-based channels (15) and at least one of the gate layers (12); and
a readout layer (17), wherein the gate stack (11) is arranged on the readout layer (17);
wherein each semiconductor-based channel (15) forms, in combination with the gate layers (12) and at least one of the dielectric layers (16), a string of charge storage capacitors (18);
wherein each string of charge storage capacitors (18) is operable as a CCD register (20); and
wherein the readout layer (17) comprises a plurality of readout stages (19) configured to individually readout stored charge from each of the CCD registers (20).

2. The CCD memory (10) according to claim 1, wherein at least one semiconductor-based channel (15) is made of a semiconductor oxide material.

3. The CCD memory (10) according to claim 2, wherein the semiconductor oxide material comprises at least one of: indium gallium zinc oxide, IGZO; indium tin oxide, ITO; indium zinc oxide, IZO.

4. The CCD memory (10) according to one of the claims 1 to 3, wherein at least one semiconductor-based channel (15) is made of a silicon-based semiconductor material or III-V semiconductor material.

5. The CCD memory (10) according to one of the claims 1 to 4, wherein each CCD register is connected to one of the readout stages (19), which is configured to readout stored charge from the connected CCD register.

6. The CCD memory (10) according to one of the claims 1 to 5, wherein each CCD register is connected to a write stage (31) configured to push charge into the CCD register.

7. The CCD memory (10) according to claim 5 or 6, wherein the readout stage (19) and the write stage (31) of the CCD register are connected to different ends of the semiconductor-based channel that is associated with the CCD register (20).

8. The CCD memory according to claim 5 or 6, wherein the readout stage (19) and the write stage (31) of the CCD register (20) are integrated with another and are connected to one end of the semiconductor-based channel (15) that is associated with the CCD register (20).

9. The CCD memory (20) according to one of the claims 1 to 8, wherein at least a part of each semiconductor-based channel (15) extends along the first direction (14) and/or extends perpendicular to parallel surfaces of the gate layers (12).

10. The CCD memory (10) according to one of the claims 1 to 9, wherein at least one semiconductor-based channel (15) is straight in the stack (11).

11. The CCD memory (10) according to one of the claims 1 to 10, wherein at least one semiconductor-based channel (15) has a bend in the stack (11), in particular, has a U-shape.

12. The CCD memory (10) according to one of the claims 1 to 11, wherein at least one semiconductor-based channel (15) is a macaroni-type channel.

13. The CCD memory (10) according to one of the claims 1 to 12, wherein each gate layer (12) surrounds one or more of the semiconductor-based channels (15).

14. The CCD memory (10) according to one of the claims 1 to 13,
wherein the gate stack (11) further comprises an input transfer-gate layer (26) and an output transfer-gate layer (27), which sandwich the gate layers (12) and the spacer layers (12) of the gate stack (11) in the first direction (14);
wherein the input transfer-gate layer (26) and the output transfer-gate layer (27) respectively comprise a plurality of transfer-gates for accessing the CCD registers (20);
wherein the output transfer-gate layer (27) of the gate stack (11) is formed on the readout layer (17), and
wherein the transfer gates of the output transfer-gate layer (27) are connected to the readout stages (19) of the readout layer (17).
